# EUROPEAN PATENT APPLICATION

(11) **EP 4 800 526 A1**
(43) Date of publication of application: **02.09.2026**
(21) Application number: 24921367.9
(22) Date of filing: 12.08.2024
(51) Int. Cl.: G06F 1/20

(54) **SERVER-SIDE LIQUID COOLING STRUCTURE, SERVER-SIDE POWER SUPPLY AND LIQUID COOLING STRUCTURE, AND DEVICE**

(30) Priority: 30.01.2024 CN 202410129092
(71) Applicant: Suzhou Metabrain Intelligent Technology Co., Ltd., Suzhou, Jiangsu 215000 (CN)
(72) Inventor: ZHANG, Hailong, Suzhou, Jiangsu 215000 (CN); ZHANG, Rufeng, Suzhou, Jiangsu 215000 (CN); GONG, Baolong, Suzhou, Jiangsu 215000 (CN)
(74) Representative: Michalski Hüttermann & Partner mbB
(86) International application number: PCT/CN2024/111521
(87) International publication number: WO 2025/161338

(57) **Abstract**

A server-side liquid cooling structure, a server-side power supply and liquid cooling structure, and a device, relating to the technical field of server design. The server-side liquid cooling structure comprises a liquid cooling module (400) and a liquid cooling quick connection module (500). The liquid cooling module (400) comprises at least one first liquid cooling pipe interface, the first liquid cooling pipe interface being fixed on one side of a server mounting part and connected to an external cooling circulation system. The liquid cooling quick connection module (500) comprises: a second liquid cooling pipe interface, fitted with the first liquid cooling pipe interface; and a sliding assembly, connected to the second liquid cooling pipe interface and used to drive the second liquid cooling pipe interface to approach or move away from the first liquid cooling pipe interface along a preset sliding path. By means of using space on a side wall of a chassis to configure a water intake space, the utilization rate of the layout space of a server is increased, and the liquid cooling structure can be centrally maintained, so that the operation and maintenance efficiency can be improved.

## Description

### CROSS-REFERENCE TO RELATED APPLICATION

The present application claims priority to Chinese patent application No. 202410129092.7, entitled "SERVER-SIDE LIQUID COOLING STRUCTURE, SERVER-SIDE POWER SUPPLY AND LIQUID COOLING STRUCTURE, AND DEVICE", filed on January 30, 2024 before the China National Intellectual Property Administration, which is incorporated herein in its entirety by reference.

### TECHNICAL FIELD

This application relates to the field of server design technology, and in particular to a server-side liquid cooling structure, a server-side power supply and liquid cooling structure, a server chassis, and a server.

### BACKGROUND

In a common liquid-cooled server, the quick-connect is generally fixed on the rear window of the chassis. The rear window of the server is usually equipped with relevant modules such as fans, power supplies, and I/O (input/output) interfaces. When servers in the cabinet are in operation, they usually need to be connected to different external cables such as power cables, data cables, and network cables. Arranging quick-connects and power supply components on the rear window will occupy space and also affect the overall heat dissipation of the system. Therefore, a correct and reasonable system layout is required to optimize the space utilization rate and heat dissipation performance of the entire chassis system. For the traditional rear-outlet architecture of servers, it is hard to efficiently dissipate heat from the network card devices located at the rear end of the server. Moreover, when system maintenance is required, the rear-outlet servers have many inconveniences both in installation and maintenance because the signal cables are arranged at the rear of the chassis. It can be seen that the existing servers have low space utilization rate and low operation and maintenance efficiency.

### SUMMARY

In view of the above, some embodiments of the present application provide a server-side liquid cooling structure, a server-side power supply and liquid cooling structure, a server chassis, and a server that overcome the above problems or at least partially solve the above problems.

To address the above problems, in a first aspect of the present disclosure, some embodiments provide a server-side liquid cooling structure, including a liquid cooling module and a liquid cooling quick-connect module.

The liquid cooling module includes at least one first liquid cooling pipe connector, the first liquid cooling pipe connector being fixed on one side of a server mounting part and connected to an external cooling circulation system.

The liquid cooling quick-connect module includes: a second liquid cooling pipe connector matched with the first liquid cooling pipe connector; and a sliding assembly connected to the second liquid cooling pipe connector, wherein the sliding assembly is operated to: drive the second liquid cooling pipe connector to move towards the first liquid cooling pipe connector along a preset sliding path to engage the first liquid cooling pipe connector with the second liquid cooling pipe connector; drive the second liquid cooling pipe connector to move away from the first liquid cooling pipe connector along the preset sliding path to disengage the first liquid cooling pipe connector from the second liquid cooling pipe connector.

In some embodiments, the liquid cooling quick-connect module further includes: a liquid cooling fixing component, located outside the sliding assembly and in contact with the sliding assembly, wherein the liquid cooling fixing component is configured to fix the sliding assembly to allow the sliding assembly to slide within the liquid cooling fixing component.

In some embodiments, the sliding assembly includes: a sliding member fixedly connected to the second liquid cooling pipe connector; and a fixed member, connected to the sliding member and configured to drive the sliding member to slide along the preset sliding path.

In some embodiments, the sliding member and the fixed member form a rack-and-pinion mechanism; the rack in the rack-and-pinion mechanism is driven to slide by rotating the pinion in the rack-and-pinion mechanism.

In some embodiments, the sliding member is the rack in the rack-and-pinion mechanism; the fixed member is the pinion in the rack-and-pinion mechanism; the sliding member is driven to slide by rotating the fixed member.

In some embodiments, the liquid cooling quick-connect module further includes: a liquid cooling manual operation member, connected to the fixed member and configured to operate the fixed member to rotate to drive the sliding member to slide.

In some embodiments, the liquid cooling manual operation member is a first rotary handle, the first rotary handle is arranged at a front end of the server mounting part.

In some embodiments, the liquid cooling quick-connect module further includes: a limiting component, located on the liquid cooling fixing component and configured to limit a sliding range of the sliding assembly.

In some embodiments, the sliding member and the fixed member form a worm and worm gear mechanism; the worm in the worm and worm gear mechanism is driven to rotate by rotating the worm gear in the worm and worm gear mechanism.

In some embodiments, the first liquid cooling pipe connector is either a male quick connecter or a female quick connecter; the second liquid cooling pipe connector is the other one of the male quick connecter and the female quick connecter.

In a second aspect of the present application, some embodiments provide a server-side power supply and liquid cooling structure, including: a power supply module, a power supply quick-connect module, and the server-side liquid cooling structure described above.

The power supply module is fixed on one side of the server mounting part. The power supply quick-connect module is connected to internal cables and configured to rotate around a preset rotation axis, and the power supply module is connected with the internal cables via the power supply quick-connect module in response to the power supply quick-connect module being connected to the power supply module. The server-side liquid cooling structure is fixed on one side of the server mounting part. The power supply quick-connect module and the liquid cooling quick-connect module of the server-side liquid cooling structure switch states synchronously.

In some embodiments, the power supply module includes: a power contactor configured to connect to an external power source; and a first electrical connector provided on the power contactor.

In some embodiments, the power supply quick-connect module includes: a second electrical connector connected to the internal cables; and a rotating member connected to the second electrical connector, wherein the rotating member is configured to rotate around the preset rotation axis to connect or disconnect the second electrical connector with the first electrical connector.

In some embodiments, the power supply quick-connect module further includes: an electrical connection operating member, connected to the rotating member and configured to operate the rotating member to rotate around the preset rotation axis.

In some embodiments, the electrical connection operating member is a second rotary handle arranged at the front end of the server mounting part.

In some embodiments, the second rotary handle is connected to the liquid cooling quick-connect module, and is further configured to operate the liquid cooling quick-connect module.

In some embodiments, the first electrical connector is either a contactor plug or a contactor receptacle; the second electrical connector is the other one of the contactor plug and the contactor receptacle.

In some embodiments, the power supply module and the server-side liquid cooling structure are located on the same side or opposite sides of the server mounting part.

In a third aspect of the present application, some embodiments provide a server chassis, including the server-side liquid cooling structure described above, or the server-side power supply and liquid cooling structure described above.

In a third aspect of the present application, some embodiments provide a server including the server chassis described above.

Some embodiments of the present application have the following advantages:
In some embodiments of the present application, the liquid cooling module includes at least one first liquid cooling pipe connector, which is fixed on one side of the server mounting part and connected to an external cooling circulation system. The liquid cooling quick-connect module includes a second liquid cooling pipe connector matched with the first liquid cooling pipe connector and a sliding assembly connected to the second liquid cooling pipe connector. The sliding assembly is operated to: drive the second liquid cooling pipe connector to move towards the first liquid cooling pipe connector along a preset sliding path to engage the first liquid cooling pipe connector with the second liquid cooling pipe connector; drive the second liquid cooling pipe connector to move away from the first liquid cooling pipe connector along the preset sliding path to disengage the first liquid cooling pipe connector from the second liquid cooling pipe connector. By arranging the liquid cooling module on one side of the chassis base, the space on the side wall of the server chassis can be utilized, improving the space utilization rate of the server chassis. Moreover, the liquid cooling quick-connect module is used for connecting the liquid cooling water pipes, realizing the connection of liquid cooling water pipes via the side wall space of the server chassis. This solves the problems of low space utilization rate of server layout and complex structural design, saves costs, and reduces the investment in labor, financial and material resources. The structure is simple, featuring easy installation, convenient maintenance and low cost.

### BRIEF DESCRIPTION OF THE DRAWINGS

FIG. 1 is a schematic structural diagram of a server-side liquid cooling structure according to some embodiments of the present application;
FIG. 2a is a diagram showing a first state of a liquid cooling quick-connect module and a liquid cooling module in the server-side liquid cooling structure according to some embodiments of the present application;
FIG. 2b is a diagram showing a second state of the liquid cooling quick-connect module and the liquid cooling module in the server-side liquid cooling structure according to some embodiments of the present application;
FIG. 3 is a structural diagram of the liquid cooling quick-connect module in the server-side liquid cooling structure according to some embodiments of the present application;
FIG. 4 is a structural diagram of a server-side power supply and liquid cooling structure according to some embodiments of the present application;
FIG. 5 is a structural diagram of a server-side power supply and liquid cooling structure according to some embodiments of the present application;
FIG. 6a is a diagram showing a first state of the power supply module and the power supply quick-connect module in the server-side power supply and liquid cooling structure according to some embodiments the present application;
FIG. 6b is a diagram showing a second state of the power supply module and the power supply quick-connect module in the server-side power supply and liquid cooling structure according to some embodiments the present application;
FIG. 7 is an exploded view of the power supply module and the power supply quick-connect module in the server-side power supply and liquid cooling structure according to some embodiments of the present application;
FIG. 8 is a structural diagram of another server-side power supply and liquid cooling structure according to some embodiments of the present application.

### List of Reference numerals

100-Server mounting part, 200-Power supply module, 210-Power contactor, 220-First electrical connector, 300-Power supply quick-connect module, 310-Second electrical connector, 320-Rotating member, 330-Electrical connection operating member, 400-Liquid cooling module, 410-First liquid cooling pipe connector, 500-Liquid cooling quick-connect module, 510-Second liquid cooling pipe connector, 520-Sliding assembly, 521-Sliding member, 522-Fixed member, 530-Liquid cooling fixing component, 540-Liquid cooling manual operation member, 550-Limiting component.

### DETAILED DESCRIPTION OF THE EMBODIMENTS

To make the above objectives, features, and advantages of the present application more apparent and understandable, the present application will be explained in details below in conjunction with the accompanying drawings and specific embodiments.

One of the core ideas of some embodiments of the present application is to enable power supplying and/or the connection of liquid cooling water pipes through the side wall space of the server chassis. By operating the structures on both sides, the liquid cooling quick-connect parts can be mated to connect the water circuit and the electrical circuit. Alternatively, by operating the structures on both sides in the opposite direction, the liquid cooling quick-connect parts can be separated, and the electrical circuit can be cut off. This addresses the server's problems such as low utilization of space layout, complex structural design, low operation and maintenance efficiency, and inconvenient operation, thereby saving costs and reducing the input of human, financial, and material resources. Moreover, the structure is simple, easy to install, convenient to maintain, and cost-effective.

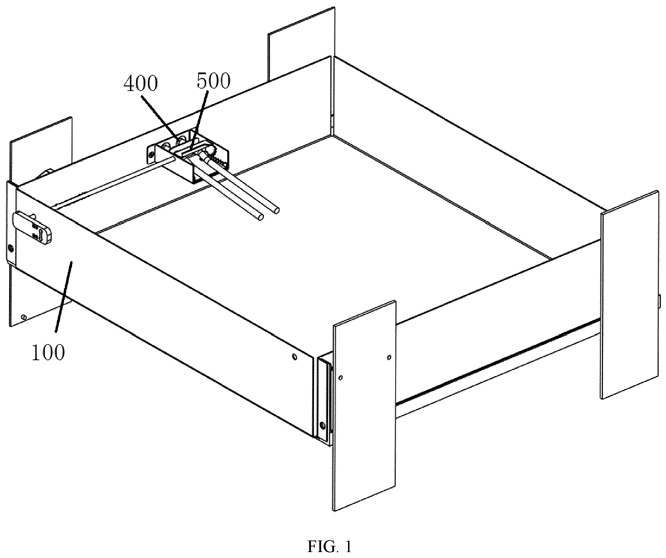

FIG. 1 is a structural block diagram of a server-side liquid cooling structure according to embodiments of the present application. The server-side liquid cooling structure can specifically include a liquid cooling module 400 and a liquid cooling quick-connect module 500.

The liquid cooling module 400 includes at least one first liquid cooling pipe connector 410. The first liquid cooling pipe connector 410 is fixed on one side of a server mounting part 100, and connected to an external cooling circulation system.

The liquid cooling quick-connect module 500 includes:
a second liquid cooling pipe connector 510 matched with the first liquid cooling pipe connector 410; and
a sliding assembly 520 connected to the second liquid cooling pipe connector 510. The second liquid cooling pipe connector 510 is driven, by operating the sliding assembly 520, to move towards the first liquid cooling pipe connector 410 along a preset sliding path, enabling the first liquid cooling pipe connector 410 to engage with the second liquid cooling pipe connector 510. Alternatively, the second liquid cooling pipe connector 510 is driven, by operating the sliding assembly 520, to move away from the first liquid cooling pipe connector 410 along the preset sliding path, enabling the first liquid cooling pipe connector 410 to separate from the second liquid cooling pipe connector 510.

In some embodiments of the present application, the liquid cooling module 400 and the liquid cooling quick-connect module 500 provide a cooling water circulation supply for the server. The liquid cooling module 400 may be located on one side of the server mounting part 100, and may be fixed on that side, providing a liquid cooling connector for the server. The liquid cooling module 400 is connected to an external cooling circulation system so that, when the external cooling circulation system is in communication with the inside of the server, a certain amount of cooling liquid can be provided for the server. The liquid cooling module 400 may include multiple first liquid cooling pipe connectors 410, for example two first liquid cooling pipe connectors 410 as shown in FIG. 1. The first liquid cooling pipe connectors 410 may be fixed on the same side of the chassis base. The server is connected to the external cooling circulation system through the first liquid cooling pipe connectors 410.

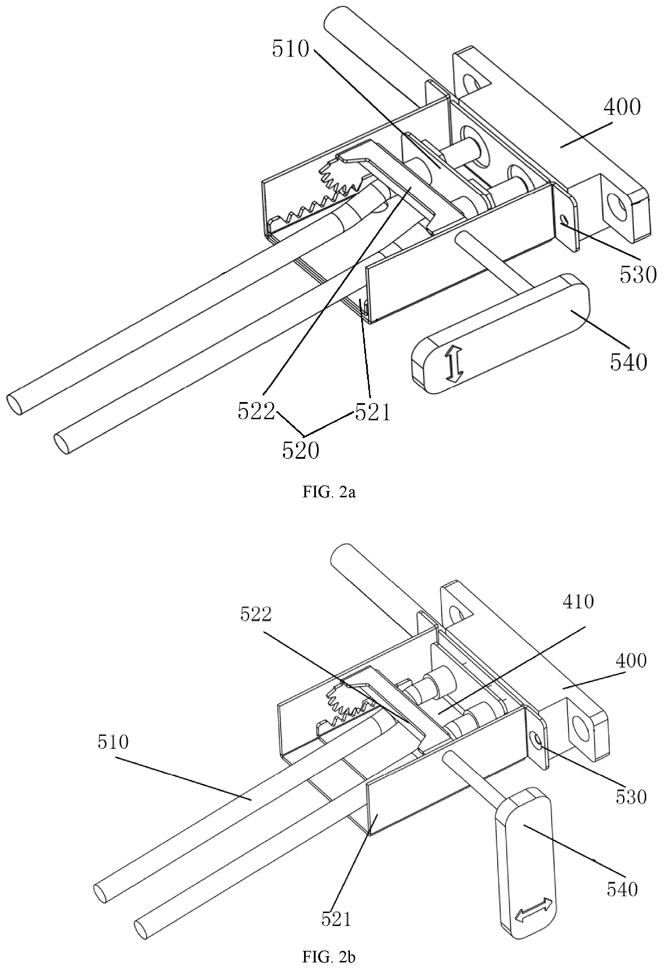

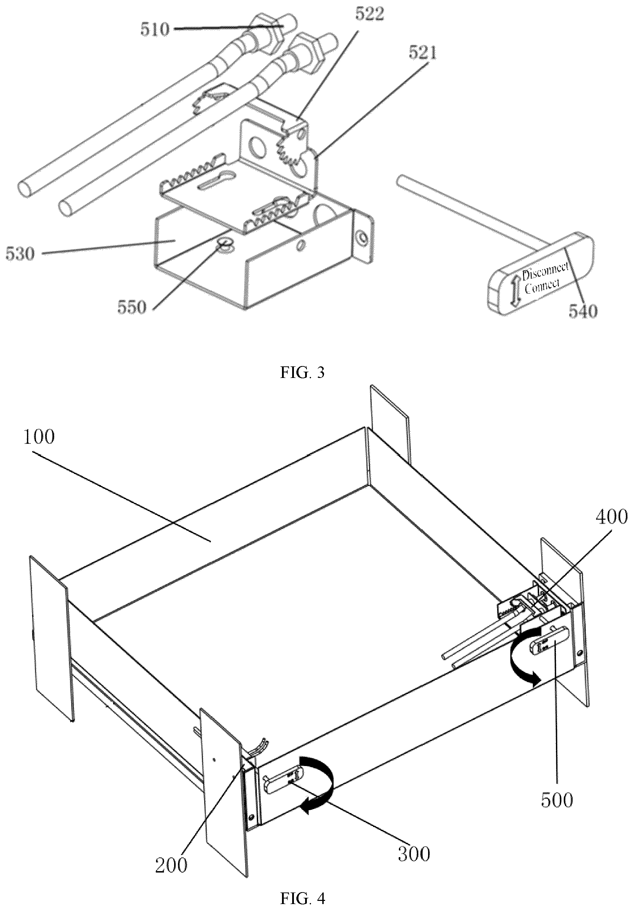

The liquid cooling quick-connect module 500 is connected to internal cooling water pipes of the server. The liquid cooling quick-connect module 500 can move along a preset sliding path towards or away from the liquid cooling module 400. When the liquid cooling quick-connect module 500 is in contact with the liquid cooling module 400, the external cooling circulation system is in communication with the internal cooling water pipes, allowing the cooling water from the external cooling circulation system to continuously flow into the internal cooling water pipes. During a liquid inlet phase, the cooling liquid flows into the internal cooling liquid distribution unit of the server through the internal cooling water pipes. The cooling liquid distribution unit then delivers the cooling liquid, via the liquid cooling quick-connect module, from a liquid inlet pipe on the side wall of the chassis to components required to be cooled for heat dissipation, such as the CPU (Central Processing Unit) liquid cooling module or the GPU (Graphics Processing Unit) liquid cooling module. During a liquid outlet phase, the cooling liquid discharged from the cold plate flows to the liquid cooling quick-connect module via the liquid outlet pipe, then flows back to the side wall of the chassis, and finally is directed back to the cooling liquid distribution unit on the cabinet. Subsequently, the cooling liquid distribution unit returns the cooling liquid to the external cooling circulation system through the internal cooling water pipes, thus completing the heat dissipation and cooling process for the server. Refer to FIG. 2a, FIG. 2b, and FIG. 3, the liquid cooling quick-connect module 500 includes: a second liquid cooling pipe connector 510 matched with the first liquid cooling pipe connector 410; a sliding assembly 520 connected to the second liquid cooling pipe connector 510. The sliding assembly 520 is configured to drive the second liquid cooling pipe connector 510 to move towards or away from the first liquid cooling pipe connector 410 along the preset sliding path.

That is, the liquid cooling quick-connect module includes the second liquid cooling pipe connector 510 matched with the first liquid cooling pipe connector 410, the sliding assembly 520, and a liquid cooling fixing component 530. Among them, the first liquid cooling pipe connector 410 and the second liquid cooling pipe connector 510 are matched with each other in terms of size and interface type, enabling them to be connected to each other.

The sliding assembly 520 is connected to the second liquid cooling pipe connector 510, and the connection between the sliding assembly 520 and the second liquid cooling pipe connector 510 may be a fixed connection. The sliding assembly 520 may move toward or away from the liquid cooling module 400 along the preset sliding path. During the sliding process of the sliding assembly 520, the second liquid cooling pipe connector 510 is driven to move toward or away from the first liquid cooling pipe connector 410 along the preset sliding path.

In some embodiments of the present application, the liquid cooling module 400 includes: at least one first liquid cooling pipe connector 410. The first liquid cooling pipe connector 410 is fixed on one side of the server mounting part 100 and connected to the external cooling circulation system. The liquid cooling quick-connect module 500 includes: the second liquid cooling pipe connector 510 matched with the first liquid cooling pipe connector 410; and the sliding assembly 520 connected to the second liquid cooling pipe connector 510. The second liquid cooling pipe connector 510 is driven by the sliding assembly 520 to move toward or away from the first liquid cooling pipe connector 410 along a preset sliding path. By arranging the liquid cooling module 400 on one side of the chassis base, the space on the side wall of the server chassis can be utilized, improving the space utilization rate of the server chassis. Moreover, the liquid cooling quick-connect module 500 is used for connecting the liquid cooling water pipes, realizing the connection of liquid cooling water pipes via the side wall space of the server chassis. This solves the problems of low space utilization rate of server layout and complex structural design, saves costs, and reduces the investment in labor, financial and material resources. The structure is simple, featuring easy installation, convenient maintenance and low cost.

In some embodiments of the present application, the liquid cooling quick-connect module 500 further includes a liquid cooling fixing component 530 that is located outside the sliding assembly 520 and in contact with the sliding assembly 520. The liquid cooling fixing component 530 is configured to fix the sliding assembly 520, so that the sliding assembly 520 slides within the liquid cooling fixing component 530.

The liquid cooling fixing component 530 is located outside the sliding assembly 520 and in contact with the sliding assembly 520. The sliding assembly 520 can slide along the surface of the liquid cooling fixing component 530, that is, the preset sliding path may be a path on the surface of the liquid cooling fixing component 530. In addition, the liquid cooling fixing component 530 partially encloses the sliding assembly 520 to fix the sliding assembly 520 and limit its sliding range.

Specifically, the sliding assembly 520 includes:
a sliding member 521 that is fixedly connected to the second liquid cooling pipe connector 510; and
a fixed member 522 that is connected to the sliding member 521 and configured to drive the sliding member 521 to slide along the preset sliding path.

The sliding assembly 520 may include a sliding member 521 and a fixed member 522. The sliding member 521 is fixedly connected to the second liquid cooling pipe connector 510. The sliding member 521 can slide along the preset path on the surface of the liquid cooling fixing component 530, and drive the second liquid cooling pipe connector 510. The fixed member 522 is fixed on the liquid cooling fixing component 530 and connected to the sliding member 521. The fixed member 522 can drive the sliding member 521 to slide along the preset sliding path, thereby enabling the second liquid cooling pipe connector 510 to connect with the first liquid cooling pipe connector 410. The fixed member 522 may be driven manually or by a motor, which is not limited in some embodiments of the present application.

Specifically, the sliding member 521 and the fixed member 522 form a rack-and-pinion mechanism. The rack in the rack-and-pinion mechanism is driven to slide by rotating the pinion in the rack-and-pinion mechanism.

In practical applications, the sliding member 521 and the fixed member 522 form a rack-and-pinion mechanism, and the sliding member 521 is driven based on the engagement of the rack-and-pinion mechanism.

Further, the sliding member 521 is the rack in the rack-and-pinion mechanism, and the fixed member 522 is the pinion in the rack-and-pinion mechanism. The sliding member 521 is driven to slide by rotating the fixed member 522.

The sliding member 521 may be the rack in the rack-and-pinion mechanism, and the fixed member 522 may be the pinion in the rack-and-pinion mechanism. When the fixed member 522 rotates, the sliding member 521 is driven to slide based on the engagement between the fixed member 522 and the sliding member 521.

In addition, the sliding member 521 and the fixed member 522 form a worm and worm gear mechanism. The worm in the worm and worm gear mechanism is driven to rotate by rotating the worm gear in the worm and worm gear mechanism.

The sliding member 521 and the fixed member 522 may form a worm and worm gear mechanism. By rotating the worm gear in the worm and worm gear mechanism, the worm in the worm and worm gear mechanism is driven to rotate, that is, the worm and worm gear mechanism can realize precise movement.

Specifically, the sliding member 521 may be the worm gear in the worm and worm gear mechanism, and the fixed member 522 may be the worm in the worm and worm gear mechanism.

In some embodiments of the present application, the liquid cooling quick-connect module 500 further includes a liquid cooling manual operation member 540 connected to the fixed member 522. The liquid cooling manual operation member 540 is configured to rotate the fixed member 522 so as to drive the sliding member 521 to slide.

In some embodiments of the present application, the fixed member 522 may be driven manually to drive the sliding member 521 to move. The liquid cooling quick-connect module further includes a liquid cooling manual operation member 540 connected to the fixed member 522. The fixed member 522 can rotate through operating the liquid cooling manual operation member 540 by the staff, thereby driving the sliding member 521 to slide.

Specifically, the liquid cooling manual operation member 540 is a first rotary handle.

The first rotary handle is arranged at the front end of the server mounting part 100.

In practical applications, the liquid cooling manual operation member 540 is a first rotary handle, and the axis of the first rotary handle is coaxial with the rotation axis of the fixed member 522. By rotating the first rotary handle, the fixed member 522 is operated to rotate, so as to drive the sliding member 521 to slide. The first rotary handle can be arranged at the front end of the server mounting part 100, which is convenient for the staff to operate the quick-connect structure of the liquid cooling system at the front end of the server mounting part 100.

In some embodiments of the present application, the liquid cooling quick-connect module 500 further includes a limiting component 550 provided on the liquid cooling fixing component 530. The limiting component 550 is configured to limit the sliding range of the sliding assembly 520.

In practical applications, at least one limiting component 550 may also be provided on the liquid cooling fixing component 530 to limit the sliding range of the sliding assembly 520.

As shown in FIG. 3, the limiting component 550 can be a pushpin, which limits the sliding range of the sliding assembly 520 using a flange.

In some embodiments of the present application, the first liquid cooling pipe connector 410 is either a male quick connecter or a female quick connecter; the second liquid cooling pipe connector 510 is the other one of the male quick connecter and the female quick connecter.

In some embodiments of the present application, the first liquid cooling pipe connector 410 is either a male quick connecter or a female quick connecter; the second liquid cooling pipe connector 510 is the other one of the male quick connecter and the female quick connecter. That is, when the first liquid cooling pipe connector 410 is a male quick connecter, the second liquid cooling pipe connector 510 is a female quick connecter. When the first liquid cooling pipe connector 410 is a female quick connecter, the second liquid cooling pipe connector 510 is a male quick connecter.

Referring to FIG. 4, a structural block diagram of an embodiment of a server-side power supply and liquid cooling structure of the present application is shown, which can specifically include the following components: a power supply module 200, a power supply quick-connect module 300, and the server-side liquid cooling structure described above.

The power supply module 200 is fixed on one side of the server mounting part 100.

The power supply quick-connect module 300 is connected to internal cables, and is configured to rotate around a preset rotation axis. When connected to the power supply module 200, the power supply quick-connect module 300 connects the power supply module 200 with the internal cables.

The server-side liquid cooling structure is fixed on one side of the server mounting part 100.

The power supply quick-connect module 300 and the liquid cooling quick-connect module 500 of the server-side liquid cooling structure switch states synchronously.

In some embodiments of the present application, the server-side power supply and liquid cooling structure can include a power supply module, a power supply quick-connect module, a liquid cooling module and a liquid cooling quick-connect module of the server-side liquid cooling structure. Among them, the power supply module 200 and the power supply quick-connect module 300 are responsible for the electrical connection supply of the server. The liquid cooling module 400 and the liquid cooling quick-connect module 500 provide the cooling water circulation supply for the server.

The power supply module 200 can be located on one side of the server mounting part 100 and can be fixed on that side, thereby providing power to the server.

The power supply quick-connect module 300 can be connected to internal cables. The power supply quick-connect module 300 can rotate around a preset rotation axis. When the power supply quick-connect module 300 rotates to be connected with the power supply module 200, the power supply module 200 is connected to the internal cables. The electrical energy of the power supply module 200 can then be transmitted to the internal power distribution board of the server through the internal cables, and the power distribution board provides centralized power supply to the equipment inside the server. This design better ensures the reliability and safety of power distribution in the cabinet, makes power maintenance in the cabinet more convenient, and improves the operation and maintenance efficiency.

The preset rotation axis can be the rotation axis of the power supply quick-connect module 300 or a reference rotation axis relative to other components, which is not limited in the present application.

The server-side liquid cooling structure can be fixed on one side of the server mounting part 100, that is, the liquid cooling module 400 can be located on one side of the server mounting part 100 and can also be fixed to that side. The liquid cooling module 400 can provide a cooling interface for the server. The liquid cooling module 400 is connected to an external cooling circulation system, and when connected to the internal part of the server, it can provide a certain amount of cooling liquid to the server.

The liquid cooling quick-connect module 500 is connected to the internal cooling water pipes of the server. The liquid cooling quick-connect module 500 can move towards or away from the liquid cooling module 400 along a preset sliding path. When the liquid cooling quick-connect module 500 is in contact with the liquid cooling module 400, the external cooling circulation system is in communication with the internal cooling water pipes, allowing the cooling water from the external cooling circulation system to continuously flow into the internal cooling water pipes. During a liquid inlet phase, the cooling liquid flows into the internal cooling liquid distribution unit of the server through the internal cooling water pipes. The cooling liquid distribution unit then delivers the cooling liquid, via the liquid cooling quick-connect module, from a liquid inlet pipe on the side wall of the chassis to components required to be cooled for heat dissipation, such as the CPU (Central Processing Unit) liquid cooling module or the GPU (Graphics Processing Unit) liquid cooling module. During a liquid outlet phase, the cooling liquid discharged from the cold plate flows to the liquid cooling quick-connect module via the liquid outlet pipe, then flows back to the side wall of the chassis, and finally is directed back to the cooling liquid distribution unit on the cabinet. Subsequently, the cooling liquid distribution unit returns the cooling liquid to the external cooling circulation system through the internal cooling water pipes, thus completing the heat dissipation and cooling process for the server.

Moreover, the power supply quick-connect module 300 and the liquid cooling quick-connect module 500 of the server-side liquid cooling structure switch states synchronously, that is, it enables simultaneous operation of water circuits and electrical circuits, allowing for concurrent connection or disconnection of water and electricity supplies.

In some embodiments of the present application, the power supply module 200 is fixed on one side of the server mounting part 100. The power supply quick-connect module 300 is connected to internal cables and configured to rotate around a preset rotation axis. When connected to the power supply module 200, the power supply quick-connect module 300 connects the power supply module 200 with the internal cables. The liquid cooling module 400 of the server-side liquid cooling structure is fixed on one side of the server mounting part 100 and connected to an external cooling circulation system. The liquid cooling quick-connect module 500 of the server-side liquid cooling structure is connected to internal cooling water pipes and configured to move toward or away from the liquid cooling module 400 along a preset sliding path. When the liquid cooling quick-connect module 500 is connected to the liquid cooling module 400, the external cooling circulation system is communication with the internal cooling water pipes. By arranging the power supply module 200 and the liquid cooling module 400 on one side of the server mounting part 100, the space on the side wall of the server chassis can be utilized, improving the space utilization rate of the server chassis. In addition, the liquid cooling water pipes and power supply lines can be connected through the liquid cooling quick-connect module 500 and the power supply quick-connect module 300 respectively, realizing the connection of liquid cooling water pipes and power supply lines via the side wall space of the server chassis. This solves the problems of low space utilization rate of server layout and complex structural design, saves costs, and reduces the investment in labor, financial and material resources. The structure is simple, featuring easy installation, convenient maintenance and low cost. Moreover, when the power supply module 200 is connected to the internal cables (i.e., when the power line connection is established), the power supply module 200 is connected to the power supply inside the chassis, and provides centralized power supply via the power supply cables. This better ensures the reliability and safety of power distribution in the cabinet, makes power maintenance in the cabinet more convenient, and improves the operation and maintenance efficiency.

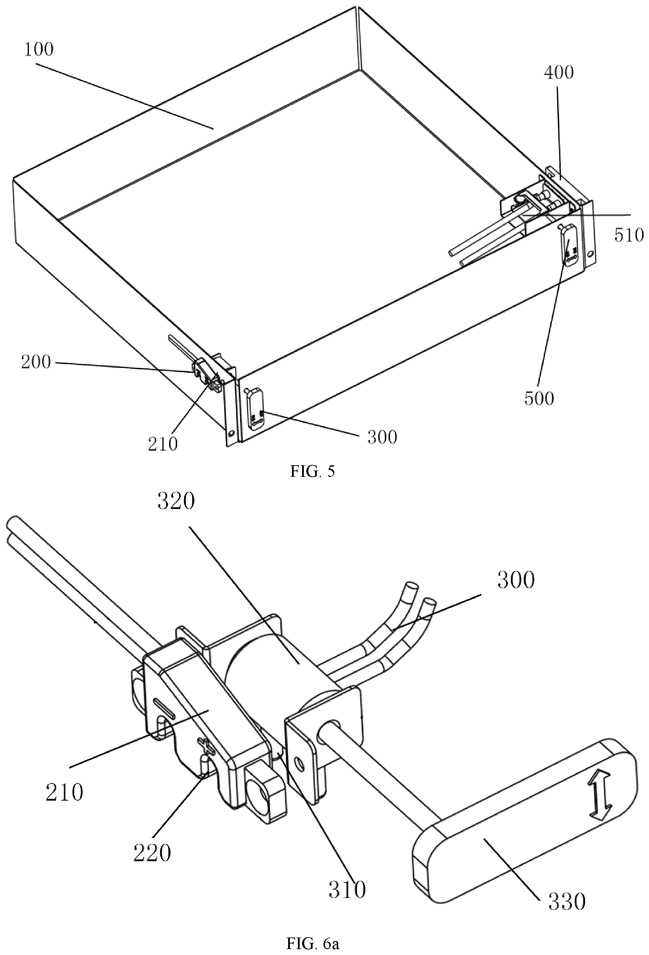

Reference may be made to FIG. 5, which shows a structural connection diagram of an embodiment of the server-side power supply and liquid cooling structure of the present application. The server-side power supply and liquid cooling structure includes: a power supply module 200, a power supply quick-connect module 300, and the aforementioned server-side liquid cooling structure.

The power supply module 200 is fixed on one side of the server mounting part 100.

The power supply quick-connect module 300 is connected to internal cables and is configured to rotate around a preset rotation axis. When connected to the power supply module 200, the power supply quick-connect module 300 connects the power supply module 200 with the internal cables.

The server-side liquid cooling structure is fixed on one side of the server mounting part 100.

The power supply quick-connect module 300 and the liquid cooling quick-connect module 500 of the server-side liquid cooling structure switch states synchronously.

In some embodiments of the present application, the power supply module 200 is located on one side of the server mounting part 100 and fixed to that side, and can provide power for the server. The liquid cooling module 400 of the server-side liquid cooling structure is located on one side of the server mounting part 100 and fixed to that side, and can provide a cooling interface for the server. The liquid cooling module 400 is connected to an external cooling circulation system, and thus can provide cooling liquid for the server when connected to the inside of the server. Herein, the power supply module 200 and the liquid cooling module 400 may be located on different sides of the server mounting part 100. As shown in FIG. 5, the power supply module 200 is fixed on the left side of the server mounting part 100, and the liquid cooling module 400 is fixed on the right side of the server mounting part 100.

The power supply quick-connect module 300 is connected to internal cables and can rotate around a preset rotation axis. When the power supply quick-connect module 300 rotates to connect with the power supply module 200, the power supply module 200 and the internal cables are connected. The electrical energy from the power supply module 200 can then flow to the power distribution board inside the server through the internal cables. The power distribution board centrally supplies power to the internal devices of the server, ensuring the reliability and safety of power distribution in the cabinet and making power maintenance in the cabinet more convenient, thereby improving operation and maintenance efficiency.

The liquid cooling quick-connect module 500 is connected to the internal cooling water pipes of the server, and can move towards or away from the liquid cooling module 400 along a preset sliding path. When the liquid cooling quick-connect module 500 reaches the liquid cooling module 400, the external cooling circulation system is in communication with the internal cooling water pipes, allowing the cooling water from the external system to continuously flow into the internal pipes.

The power supply quick-connect module 300 and the liquid cooling quick-connect module 500 of the server-side liquid cooling structure can switch states synchronously, thereby achieving simultaneous disconnection or connection of water and electricity.

The server mounting part 100 can be a server chassis.

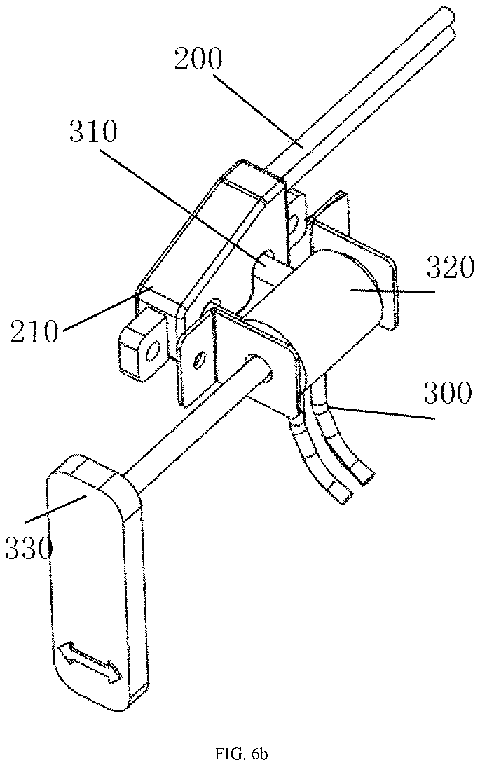

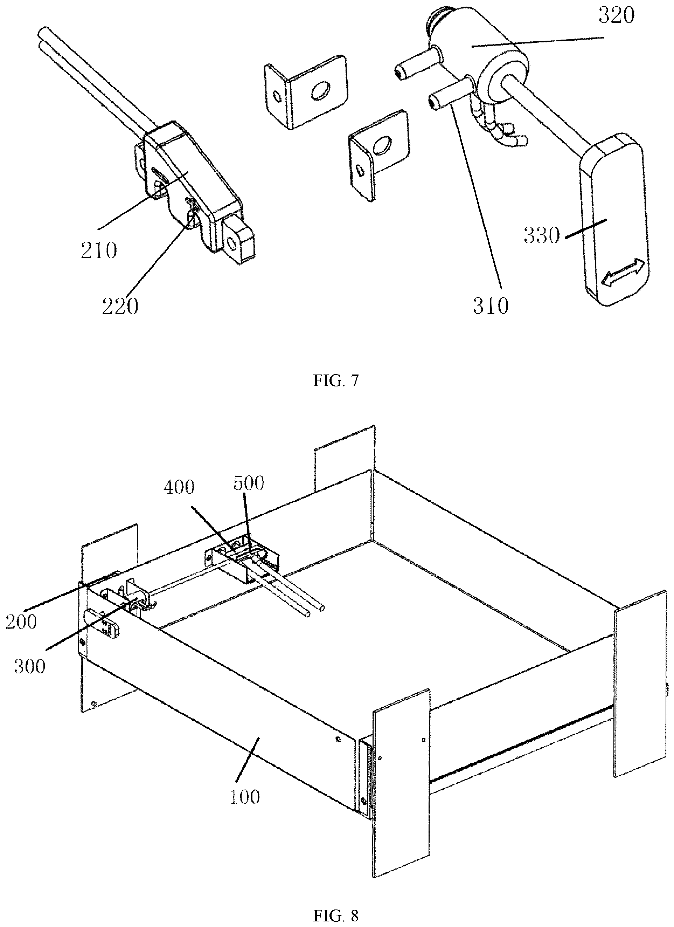

In some embodiments of the present application, as shown in FIG. 6a, FIG. 6b, and FIG. 7, the power supply module 200 includes:
a power contactor 210 configured to connect to an external power source; and
a first electrical connector 220 provided on the power contactor 210.

In some embodiments of the present application, the power supply module 200 includes a power contactor 210 and a first electrical connector 220. The power contactor 210 is connected to an external power source, so that the power contactor 210 can supply power to the server when connected to the power supply quick-connect module 300. A groove may be formed on the power contactor 210, and the first electrical connector 220 may be disposed on the power contactor 210, specifically on the groove of the power contactor 210.

Correspondingly, the power supply quick-connect module 300 includes:
a second electrical connector 310 connected to internal cables; and
a rotating member 320, connected to the second electrical connector 310 and configured to rotate around a preset rotation axis to connect or disconnect the second electrical connector 310 with the first electrical connector 220.

In some embodiments of the present application, the power supply quick-connect module 300 may include a second electrical connector 310 and a rotating member 320. The second electrical connector 310 and the first electrical connector 220 are matched with each other so that they can conduct the same current without being damaged. The second electrical connector 310 may be connected to internal cables, thus when connected to the first electrical connector 220, it can connect the internal cables with the external power source. The rotating member 320 is connected to the second electrical connector 310, and can rotate around a preset rotation axis, for example, the rotation axis of the rotating member 320, so as to connect or disconnect the second electrical connector 310 with the first electrical connector 220. The rotation of the rotating member 320 may be driven manually or by a motor, which is not limited in some embodiments of the present application.

In some embodiments of the present application, the power supply quick-connect module 300 further includes:
an electrical connection operating member 330, connected to the rotating member 320 and configured to operate the rotating member 320 to rotate around the preset rotation axis.

In some embodiments of the present application, the rotating member 320 may be driven manually. The power supply quick-connect module 300 may further include an electrical connection operating member 330. The electrical connection operating member 330 is connected to the rotating member 320. The rotating member 320 is driven to rotate around the preset rotation axis by operating the electrical connection operating member 330 to rotate, thereby driving the second electrical connector 310 to connect or disconnect with the first electrical connector 220.

Specifically, the electrical connection operating member 330 is a second rotary handle disposed at the front end of the server mounting part 100.

In practical applications, the electrical connection operating member 330 may be a second rotary handle. The second rotary handle and the first rotary handle may be the same rotary handle or different rotary handles, which is not specifically limited in some embodiments of the present application. The second rotary handle can rotate around its own rotation axis to drive the rotating member 320 to rotate. The second rotary handle may be disposed at the front end of the server mounting part 100 to facilitate the convenience of staff for power maintenance.

Further, the second rotary handle is connected to the liquid cooling quick-connect module 500 and is also used for operating the liquid cooling quick-connect module 500.

In some embodiments of the present application, the second rotary handle may be connected to the liquid cooling quick-connect module 500, and the state of the liquid cooling quick-connect module 500 is changed through the second rotary handle. That is, the fixed member 522 of the liquid cooling quick-connect module 500 and the rotating member 320 of the power supply quick-connect module 300 can be switched simultaneously through the second rotary handle.

In some embodiments of the present application, the first electrical connector 220 is either a contactor plug or a contactor receptacle; the second electrical connector 310 is the other one of the contactor plug and the contactor receptacle.

In some embodiments of the present application, the first electrical connector 220 is either a contactor plug or a contactor receptacle; the second electrical connector 310 is the other one of the contactor plug and the contactor receptacle, so that a stable connection can be achieved through a matched connector mode. When the first electrical connector 220 is a contactor plug, the second electrical connector 310 is a contactor receptacle. When the first electrical connector 220 is a contactor receptacle, the second electrical connector 310 is a contactor plug.

In some embodiments of the present application, the power supply module 200 is fixed on one side of the server mounting part 100; the power supply quick-connect module 300 is connected to internal cables, and configured to rotate around a preset rotation axis, and connect the power supply module 200 with the internal cables when connected to the power supply module 200; the liquid cooling module 400 is fixed on one side of the server mounting part 100 and connected to an external cooling circulation system; the liquid cooling quick-connect module 500 is connected to internal cooling water pipes, and configured to move toward or away from the liquid cooling module 400 along a preset sliding path, and connect the external cooling circulation system with the internal cooling water pipes when connected to the liquid cooling interface module. By arranging the power supply module 200 and the liquid cooling module 400 on one side of the server mounting part 100, the space on the side wall of the server chassis can be utilized, improving the space utilization rate of the server chassis. In addition, the liquid cooling water pipes and power supply lines can be connected through the power supply quick-connect module 300 and the liquid cooling quick-connect module 500 respectively, realizing the connection of liquid cooling water pipes and power supply lines via the side wall space of the server chassis. This solves the problems of low space utilization rate of server layout and complex structural design, saves costs, and reduces the investment in labor, financial and material resources. The structure is simple, featuring easy installation, convenient maintenance and low cost. Moreover, when the power supply module 200 is connected to the internal cables (i.e., when the power line connection is established), the power supply module 200 is connected to the power supply inside the chassis, and provides centralized power supply via the power supply cables. This better ensures the reliability and safety of power distribution in the cabinet, makes power maintenance in the cabinet more convenient, and improves the operation and maintenance efficiency. Furthermore, both the first rotary handle for operating the liquid supply quick connector and the second rotary handle for operating the electrical connection are disposed at the front end of the server, which facilitates operators to conveniently cut off or connect the cooling liquid supply and power supply, thereby improving the operation efficiency.

Reference may be made to FIG. 8, which shows a structural diagram of a server-side power supply and liquid cooling structure according to another embodiment of the present application. The server-side power supply and liquid cooling structure includes a power supply module 200, a power supply quick-connect module 300, and the aforementioned server-side liquid cooling structure.

The power supply module 200 is fixed on one side of the server mounting part 100.

The power supply quick-connect module 300 is connected to internal cables, and configured to rotate around a preset rotation axis, and connect the power supply module 200 with the internal cables when connected to the power supply module 200.

The server-side liquid cooling structure is fixed on one side of the server mounting part 100.

The power supply quick-connect module 300 and the liquid cooling quick-connect module 500 of the server-side liquid cooling structure switch states synchronously.

The power supply module and the server-side liquid cooling structure are located on the same side of the server mounting part 100.

In some embodiments of the present application, the server mounting part 100, the power supply module, the power supply quick-connect module, the liquid cooling module of the server-side liquid cooling structure, and the liquid cooling quick-connect module of the server-side liquid cooling structure may refer to the above embodiments, which will not be repeated here.

Herein, the power supply module and the liquid cooling module are located on the same side of the server mounting part 100, so that maintenance of both the electrical part and the cooling liquid supply part of the server can be performed on one side of the chassis, improving the operation and maintenance efficiency.

In some embodiments of the present application, the power supply module is fixed on one side of the server mounting part; the power supply quick-connect module is connected to the internal cables, and configured to: rotate around a preset rotation axis, and connect the power supply module with the internal cables when connected to the power supply module; the liquid cooling module 400 is fixed on one side of the server mounting part and connected to an external cooling circulation system; the liquid cooling quick-connect module 500 is connected to internal cooling water pipes, and configured to: move toward or away from the liquid cooling module 400 along a preset sliding path, and connect the external cooling circulation system with the internal cooling water pipes when connected to the liquid cooling interface module. By arranging the power supply module and the liquid cooling module 400 on the same side of the server mounting part, the space on the side wall of the server chassis can be utilized, improving the space utilization rate of the server chassis. In addition, the liquid cooling water pipes and power supply lines can be connected through the power supply quick-connect module and the liquid cooling quick-connect module 500 respectively, realizing the connection of liquid cooling water pipes and power supply lines via the side wall space of the server chassis. Moreover, when the power supply module is connected to the internal cables (i.e., when the power line connection is established), the power supply module is connected to the power supply inside the chassis, and provides centralized power supply via the power supply cables. This better ensures the reliability and safety of power distribution in the cabinet, makes power maintenance in the cabinet more convenient, and improves the operation and maintenance efficiency.

It should be noted that for some embodiments of the present application, in order to simplify the description, they are all described as a series of action combinations. However, those skilled in the art should know that some embodiments of the present application are not limited by the described order of actions, because according to some embodiments of the present application, some steps can be carried out in other orders or simultaneously. Secondly, those skilled in the art should also know that the embodiments described in the specification are all preferred embodiments, and the actions involved are not necessarily required for some embodiments of the present application.

Some embodiments of the present application also provide a server chassis including the server-side liquid cooling structure or the server-side power supply and liquid cooling structure described above.

The server-side liquid cooling structure includes a liquid cooling module and a liquid cooling quick-connect module.

The liquid cooling module includes at least one first liquid cooling pipe connector. The first liquid cooling pipe connector is fixed on one side of the server mounting part, and connected to an external cooling circulation system.

The liquid cooling quick-connect module includes:
a second liquid cooling pipe connector matched with the first liquid cooling pipe connector; and
a sliding assembly connected to the second liquid cooling pipe connector.

The second liquid cooling pipe connector is driven, by operating the sliding assembly, to move towards the first liquid cooling pipe connector along a preset sliding path, so that the first liquid cooling pipe connector is in contact with the second liquid cooling pipe connector. Alternatively, the second liquid cooling pipe connector is driven, by operating the sliding assembly, to move away from the first liquid cooling pipe connector along the preset sliding path, so that the first liquid cooling pipe connector is separated from the second liquid cooling pipe connector.

In some embodiments, the liquid cooling quick-connect module further includes a liquid cooling fixing component that is located outside the sliding assembly and in contact with the sliding assembly. The liquid cooling fixing component is configured to fix the sliding assembly, so that the sliding assembly slides within the liquid cooling fixing component.

In some embodiments, the sliding assembly includes:
a sliding member that is fixedly connected to the second liquid cooling pipe connector; and
a fixed member, connected to the sliding member and configured to drive the sliding member to slide along the preset sliding path.

In some embodiments, the sliding member and the fixed member form a rack-and-pinion mechanism. The rack of the mechanism slides by rotating the pinion in the rack-and-pinion mechanism.

In some embodiments, the sliding member is the rack in the rack-and-pinion mechanism, the fixed member is the pinion in the rack-and-pinion mechanism. The sliding member is driven to slide by rotating the fixed member.

In some embodiments, the liquid cooling quick-connect module further includes a liquid cooling manual operation member connected to the fixed member. The liquid cooling manual operation member is configured to operate the fixed member to rotate, thereby driving the sliding member to slide.

In some embodiments, the liquid cooling manual operation member is a first rotary handle,
The first rotary handle is provided at the front end of the server mounting part.

In some embodiments, the liquid cooling quick-connect module further includes a limiting component located on the liquid cooling fixing component. The limiting component is configured to limit the sliding range of the sliding assembly.

In some embodiments, the sliding member and the fixed member form a worm and worm gear mechanism. The worm in the worm and worm gear mechanism is driven to rotate by rotating the worm gear in the worm and worm gear mechanism.

In some embodiments, the first liquid cooling pipe connector is a male quick connector or female quick connector, and the second liquid cooling pipe connector is the other one of the male quick connector and female quick connector.

The server-side power supply and liquid cooling structure includes a power supply module, a power supply quick-connect module, and the server-side liquid cooling structure described above.

The power supply module is fixed on one side of the server mounting part.

The power supply quick-connect module is connected to internal cables, and is configured to rotate around a preset rotation axis. When connected to the power supply module, the power supply quick-connect module connects the power supply module with the internal cables.

The server-side liquid cooling structure is fixed on one side of the server mounting part.

The power supply quick-connect module and the liquid cooling quick-connect module of the server-side liquid cooling structure switch states synchronously.

In some embodiments, the power supply module includes: a power contactor configured to connect to an external power source; and a first electrical connector provided on the power contactor.

In some embodiments, the power supply quick-connect module includes: a second electrical connector connected to internal cables; and a rotating member, connected to the second electrical connector and configured to rotate around a preset rotation axis to connect or disconnect the second electrical connector with the first electrical connector.

In some embodiments, the power supply quick-connect module further includes:
an electrical connection operating member, connected to the rotating member and configured to operate the rotating member to rotate around the preset rotation axis.

In some embodiments, the electrical connection operating member is a second rotary handle arranged at the front end of the server mounting part.

In some embodiments, the second rotary handle is connected to the liquid cooling quick-connect module, and is also configured to operate the liquid cooling quick-connect module.

In some embodiments, the first electrical connector is either a contactor plug or a contactor receptacle, and the second electrical connector is the other one of the contactor plug or the contactor receptacle.

In some embodiments, the power supply module and the server-side liquid cooling structure are located on the same side or opposite sides of the server mounting part.

In some embodiments of the present application, the power supply module is fixed on one side of the server mounting part; the power supply quick-connect module is connected to internal cables, and configured to rotate around a preset rotation axis, and connect the power supply module with the internal cables when connected to the power supply module; the liquid cooling module is fixed on one side of the server mounting part and connected to an external cooling circulation system; the liquid cooling quick-connect module is connected to internal cooling water pipes, and configured to move toward or away from the liquid cooling module along a preset sliding path, and connect the external cooling circulation system with the internal cooling water pipes when connected to the liquid cooling interface module. By arranging the power supply module and the liquid cooling module on one side of the server mounting part, the space on the side wall of the server chassis can be utilized, improving the space utilization rate of the server chassis. In addition, the liquid cooling water pipes and power supply lines can be connected through the power supply quick-connect module and the liquid cooling quick-connect module respectively, realizing the connection of liquid cooling water pipes and power supply lines via the side wall space of the server chassis. This solves the problems of low space utilization rate of server layout and complex structural design, saves costs, and reduces the investment in labor, financial and material resources. The structure is simple, featuring easy installation, convenient maintenance and low cost. Moreover, when the power supply module is connected to the internal cables (i.e., when the power line connection is established), the power supply module is connected to the power supply inside the chassis, and provides centralized power supply via the power supply cables. This better ensures the reliability and safety of power distribution in the cabinet, makes power maintenance in the cabinet more convenient, and improves the operation and maintenance efficiency.

Some embodiments of the present application also provide a server including the aforementioned server chassis. The server chassis includes the aforementioned server-side liquid cooling structure, or the aforementioned server-side power supply and liquid cooling structure.

Specifically, the server-side liquid cooling structure includes a liquid cooling module and a liquid cooling quick-connect module.

The liquid cooling module includes at least one first liquid cooling pipe connector. The first liquid cooling pipe connector is fixed on one side of the server mounting part, and connected to an external cooling circulation system.

The liquid cooling quick-connect module includes: a second liquid cooling pipe connector matched with the first liquid cooling pipe connector; and a sliding assembly connected to the second liquid cooling pipe connector.

The second liquid cooling pipe connector is driven, by operating the sliding assembly, to move towards the first liquid cooling pipe connector along a preset sliding path, so that the first liquid cooling pipe connector is in contact with the second liquid cooling pipe connector. Alternatively, the second liquid cooling pipe connector is driven, by operating the sliding assembly, to move away from the first liquid cooling pipe connector along the preset sliding path, so that the first liquid cooling pipe connector is separated from the second liquid cooling pipe connector.

In some embodiments, the liquid cooling quick-connect module further includes a liquid cooling fixing component that is located outside the sliding assembly and in contact with the sliding assembly. The liquid cooling fixing component is configured to fix the sliding assembly, so that the sliding assembly slides within the liquid cooling fixing component.

In some embodiments, the sliding assembly includes:
a sliding member that is fixedly connected to the second liquid cooling pipe connector; and
a fixed member, connected to the sliding member and configured to drive the sliding member to slide along the preset sliding path.

In some embodiments, the sliding member and the fixed member form a rack-and-pinion mechanism. The rack of the mechanism is driven to slide by rotating the pinion in the rack-and-pinion mechanism.

In some embodiments, the sliding member is the rack in the rack-and-pinion mechanism, the fixed member is the pinion in the rack-and-pinion mechanism. The sliding member is driven to slide by rotating the fixed member.

In some embodiments, the liquid cooling quick-connect module further includes a liquid cooling manual operation member connected to the fixed member. The liquid cooling manual operation member is configured to operate the fixed member to rotate, thereby driving the sliding member to slide.

In some embodiments, the liquid cooling manual operation member is a first rotary handle provided at the front end of the server mounting part.

In some embodiments, the liquid cooling quick-connect module further includes a limiting component located on the liquid cooling fixing component. The limiting component is configured to limit the sliding range of the sliding assembly.

In some embodiments, the sliding member and the fixed member form a worm and worm gear mechanism. The worm in the worm and worm gear mechanism is driven to rotate by rotating the worm gear in the worm and worm gear mechanism.

In some embodiments, the first liquid cooling pipe connector is a male quick connector or female quick connector, and the second liquid cooling pipe connector is the other one of the male quick connector or female quick connector.

The server-side power supply and liquid cooling structure includes a power supply module, a power supply quick-connect module, and the server-side liquid cooling structure described above.

The power supply module is fixed on one side of the server mounting part.

The power supply quick-connect module is connected to internal cables, and is configured to rotate around a preset rotation axis. When connected to the power supply module, the power supply quick-connect module connects the power supply module with the internal cables.

The server-side liquid cooling structure is fixed on one side of the server mounting part.

The power supply quick-connect module and the liquid cooling quick-connect module of the server-side liquid cooling structure switch states synchronously.

In some embodiments, the power supply module includes: a power contactor configured to connect to an external power source; and a first electrical connector provided on the power contactor.

In some embodiments, the power supply quick-connect module includes: a second electrical connector connected to internal cables; and a rotating member, connected to the second electrical connector and configured to rotate around a preset rotation axis to connect or disconnect the second electrical connector with the first electrical connector.

In some embodiments, the power supply quick-connect module further includes:
an electrical connection operating member, connected to the rotating member and configured to operate the rotating member to rotate around the preset rotation axis.

In some embodiments, the electrical connection operating member is a second rotary handle arranged at the front end of the server mounting part.

In some embodiments, the second rotary handle is connected to the liquid cooling quick-connect module, and is also configured to operate the liquid cooling quick-connect module.

In some embodiments, the first electrical connector is either a contactor plug or a contactor receptacle, and the second electrical connector is the other one of the contactor plug or the contactor receptacle.

In some embodiments, the power supply module and the server-side liquid cooling structure are located on the same side or opposite sides of the server mounting part.

In some embodiments of the present application, the power supply module is fixed on one side of the server mounting part; the power supply quick-connect module is connected to internal cables, and configured to rotate around a preset rotation axis, and connect the power supply module with the internal cables when connected to the power supply module; the liquid cooling module is fixed on one side of the server mounting part and connected to an external cooling circulation system; the liquid cooling quick-connect module is connected to internal cooling water pipes, and configured to move toward or away from the liquid cooling module along a preset sliding path, and connect the external cooling circulation system with the internal cooling water pipes when connected to the liquid cooling interface module. By arranging the power supply module and the liquid cooling module on one side of the server mounting part, the space on the side wall of the server chassis can be utilized, improving the space utilization rate of the server chassis. In addition, the liquid cooling water pipes and power supply lines can be connected through the power supply quick-connect module and the liquid cooling quick-connect module respectively, realizing the connection of liquid cooling water pipes and power supply lines via the side wall space of the server chassis. This solves the problems of low space utilization rate of server layout and complex structural design, saves costs, and reduces the investment in labor, financial and material resources. The structure is simple, featuring easy installation, convenient maintenance and low cost. Moreover, when the power supply module is connected to the internal cables (i.e., when the power line connection is established), the power supply module is connected to the power supply inside the chassis, and provides centralized power supply via the power supply cables. This better ensures the reliability and safety of power distribution in the cabinet, makes power maintenance in the cabinet more convenient, and improves the operation and maintenance efficiency.

The embodiments in this specification are described in a progressive manner. The focus of some embodiments is on the differences from other embodiments. The identical or similar parts among the various embodiments can be referred to each other.

Those skilled in this field should understand that the embodiments of the present application can be provided as methods, devices, or computer program products. Therefore, the present application can take the form of entirely hardware embodiments, entirely software embodiments, or embodiments combining software and hardware aspects. Moreover, the present application can take the form of a computer program product implemented on one or more computer-readable storage media (including but not limited to disk storage, CD-ROM, optical storage, etc.) containing computer program code.

The present application is described with reference to the flowcharts and/or block diagrams of methods, terminal devices (systems), and computer program products according to the embodiments of the present application. It should be understood that each block in the flowcharts and/or block diagrams, and combinations of blocks in the flowcharts and/or block diagrams, can be implemented by computer program instructions. These computer program instructions can be provided to the processor of a general-purpose computer, a special-purpose computer, an embedded processor, or other programmable data processing terminal devices to produce a machine, such that the instructions executed by the processor of the computer or other programmable data processing terminal devices create means for implementing the functions specified in one block or multiple blocks of the flowcharts and/or block diagrams.

These computer program instructions can also be stored in a computer-readable memory that can direct a computer or other programmable data processing terminal devices to operate in a particular manner, such that the instructions stored in the computer-readable memory produce an article of manufacture including instruction means that implement the functions specified in one block or multiple blocks of the flowcharts and/or block diagrams.

These computer program instructions can also be loaded onto a computer or other programmable data processing terminal devices, such that a series of operational steps are performed on the computer or other programmable terminal devices to produce a computer-implemented process, thereby providing steps for implementing the functions specified in one block or multiple blocks of the flowcharts and/or block diagrams.

Although the preferred embodiments of the present application have been described, technicians in the field, once they have grasped the basic inventive concept, can make additional changes and modifications to these embodiments. Therefore, the appended claims are intended to cover the preferred embodiments and all changes and modifications that fall within the scope of the present application.

Finally, it should also be noted that relational terms such as "first" and "second" are used merely to distinguish one entity or operation from another, and do not necessarily require or imply any such actual relationship or order between these entities or operations. Moreover, the terms "comprising," "including," or any other variants are intended to cover non-exclusive inclusions, such that a process, method, item, or terminal device that includes a series of elements not only includes those elements but also includes other elements not explicitly listed, or elements inherent to such process, method, item, or terminal device. In the absence of more limitations, an element defined by the phrase "including a..." does not exclude the presence of additional identical elements in the process, method, item, or terminal device that includes the element.

The server-side liquid cooling structure, the server-side power supply and liquid cooling structure, the server chassis, and the server provided by the present application have been introduced in detail above. The principles and implementation methods of the present application have been elaborated through specific examples in this text. The descriptions of the above embodiments are intended to help understand the methods and core ideas of the present application. Moreover, for those skilled in the art, based on the ideas of the present application, there will be changes in the specific implementation methods and application scopes. In summary, the content of this specification should not be interpreted as a limitation on the present application.

## Claims

1. A server-side liquid cooling structure, comprising a liquid cooling module and a liquid cooling quick-connect module,
the liquid cooling module comprises at least one first liquid cooling pipe connector, the first liquid cooling pipe connector being fixed on one side of a server mounting part and connected to an external cooling circulation system;
the liquid cooling quick-connect module comprises:
a second liquid cooling pipe connector matched with the first liquid cooling pipe connector; and
a sliding assembly connected to the second liquid cooling pipe connector, wherein the sliding assembly is operated to: drive the second liquid cooling pipe connector to move towards the first liquid cooling pipe connector along a preset sliding path to engage the first liquid cooling pipe connector with the second liquid cooling pipe connector; drive the second liquid cooling pipe connector to move away from the first liquid cooling pipe connector along the preset sliding path to disengage the first liquid cooling pipe connector from the second liquid cooling pipe connector.

2. The server-side liquid cooling structure according to claim 1, wherein the liquid cooling quick-connect module further comprises:
a liquid cooling fixing component, located outside the sliding assembly and in contact with the sliding assembly, wherein the liquid cooling fixing component is configured to fix the sliding assembly to allow the sliding assembly to slide within the liquid cooling fixing component.

3. The server-side liquid cooling structure according to claim 2, wherein the sliding assembly comprises:
a sliding member fixedly connected to the second liquid cooling pipe connector; and
a fixed member, connected to the sliding member and configured to drive the sliding member to slide along the preset sliding path.

4. The server-side liquid cooling structure according to claim 3, wherein the sliding member and the fixed member form a rack-and-pinion mechanism; the rack in the rack-and-pinion mechanism is driven to slide by rotating the pinion in the rack-and-pinion mechanism.

5. The server-side liquid cooling structure according to claim 4, wherein
the sliding member is the rack in the rack-and-pinion mechanism;
the fixed member is the pinion in the rack-and-pinion mechanism;
the sliding member is driven to slide by rotating the fixed member.

6. The server-side liquid cooling structure according to claim 3, wherein the liquid cooling quick-connect module further comprises:
a liquid cooling manual operation member, connected to the fixed member and configured to operate the fixed member to rotate to drive the sliding member to slide.

7. The server-side liquid cooling structure according to claim 6, wherein the liquid cooling manual operation member is a first rotary handle,
the first rotary handle is arranged at a front end of the server mounting part.

8. The server-side liquid cooling structure according to claim 2, wherein the liquid cooling quick-connect module further comprises:
a limiting component, located on the liquid cooling fixing component and configured to limit a sliding range of the sliding assembly.

9. The server-side liquid cooling structure according to claim 4, wherein the sliding member and the fixed member form a worm and worm gear mechanism; the worm in the worm and worm gear mechanism is driven to rotate by rotating the worm gear in the worm and worm gear mechanism.

10. The server-side liquid cooling structure according to claim 1, wherein
the first liquid cooling pipe connector is either a male quick connecter or a female quick connecter;
the second liquid cooling pipe connector is the other one of the male quick connecter and the female quick connecter.

11. A server-side power supply and liquid cooling structure, comprising: a power supply module, a power supply quick-connect module, and the server-side liquid cooling structure according to any one of claims 1 to 10,
wherein the power supply module is fixed on one side of the server mounting part;
the power supply quick-connect module is connected to internal cables and configured to rotate around a preset rotation axis, and the power supply module is connected with the internal cables via the power supply quick-connect module in response to the power supply quick-connect module being connected to the power supply module;
the server-side liquid cooling structure is fixed on one side of the server mounting part;
the power supply quick-connect module and the liquid cooling quick-connect module of the server-side liquid cooling structure switch states synchronously.

12. The server-side power supply and liquid cooling structure according to claim 11, wherein the power supply module comprises:
a power contactor configured to connect to an external power source; and
a first electrical connector provided on the power contactor.

13. The server-side power supply and liquid cooling structure according to claim 12, wherein the power supply quick-connect module comprises:
a second electrical connector connected to the internal cables; and
a rotating member connected to the second electrical connector, wherein the rotating member is configured to rotate around the preset rotation axis to connect or disconnect the second electrical connector with the first electrical connector.

14. The server-side power supply and liquid cooling structure according to claim 13, wherein the power supply quick-connect module further comprises:
an electrical connection operating member, connected to the rotating member and configured to operate the rotating member to rotate around the preset rotation axis.

15. The server-side power supply and liquid cooling structure according to claim 14, wherein the electrical connection operating member is a second rotary handle,
the second rotary handle is arranged at the front end of the server mounting part.

16. The server-side power supply and liquid cooling structure according to claim 15, wherein
the second rotary handle is connected to the liquid cooling quick-connect module, and is further configured to operate the liquid cooling quick-connect module.

17. The server-side power supply and liquid cooling structure according to claim 13, wherein
the first electrical connector is either a contactor plug or a contactor receptacle;
the second electrical connector is the other one of the contactor plug and the contactor receptacle.

18. The server-side power supply and liquid cooling structure according to claim 11, wherein the power supply module and the server-side liquid cooling structure are located on the same side or opposite sides of the server mounting part.

19. A server chassis, comprising the server-side liquid cooling structure according to any one of claims 1 to 10, or the server-side power supply and liquid cooling structure according to any one of claims 11 to 18.

20. A server comprising the server chassis according to claim 19.
